# DEMANDE DE BREVET EUROPEEN

(11) **EP 3 333 645 A1**
(43) Date de publication de la demande: **13.06.2018**
(21) Numéro de dépôt: 16202476.4
(22) Date de dépôt: 06.12.2016
(51) Int. Cl.: G04C 3/00

(54) **OBJET PORTABLE COMPRENANT UNE TIGE DE COMMANDE ROTATIVE DONT L'ACTIONNEMENT EST DÉTECTÉ PAR MESURE D'UNE INDUCTION MAGNÉTIQUE**

(71) Demandeur: ETA SA Manufacture Horlogère Suisse, 2540 Grenchen (CH)
(72) Inventeur: Zanesco, Vittorio, 2000 Neuchâtel (CH); Lagorgette, Pascal, 2502 Bienne (CH); Meyer, Pascal, 2000 Neuchâtel (CH); Schmutz, Damien, 1585 Salavaux (CH); Balmer, Raphaël, 2824 Vicques (CH)
(74) Mandataire: Supper, Marc

(57) **Abrégé**

Objet portable comprenant un bâti (2) agencé pour servir de berceau à une tige de commande (4) dont l'actionnement en rotation permet de commander au moins une fonction électronique ou mécanique de l'objet portable, un anneau aimanté (18) étant entraîné en rotation par la tige de commande (4), la rotation de l'anneau aimanté (18) étant détectée par au moins un capteur inductif (150) disposé dans un logement (156) du bâti (2) à l'intérieur duquel le capteur inductif (150) est maintenu par des moyens élastiques.

## Description

### Domaine technique de l'invention

La présente invention concerne un objet portable de petites dimensions tel qu'une pièce d'horlogerie comprenant une tige de commande rotative pour la commande d'au moins une fonction électronique ou mécanique de l'objet portable. Plus précisément, l'invention concerne un tel objet portable dont l'actionnement de la tige de commande rotative est détecté par mesure d'une induction magnétique.

### Arrière-plan technologique de l'invention

La présente invention concerne des objets portables de petites dimensions tels que des montres-bracelets qui comprennent une tige de commande rotative dont l'actionnement permet de commander une fonction mécanique ou électronique de l'objet portable dans lequel la tige de commande rotative est agencée.

Pour la bonne exécution de la fonction mécanique ou électronique concernée, il est nécessaire de pouvoir détecter l'actionnement de la tige de commande rotative. Parmi les différentes solutions envisageables, l'une consiste à mesurer la variation de l'induction magnétique induite par la rotation d'un aimant solidaire de la tige de commande. Pour détecter cette variation d'induction magnétique, on peut avoir recours à un capteur magnétique du type à effet Hall qui est capable de mesurer la valeur de l'induction magnétique du milieu dans lequel il se trouve.

Un problème récurrent qui se pose dans le domaine de la détection de la rotation d'une tige de commande par mesure d'une induction magnétique est celui de la reproductibilité de la mesure d'un objet portable à l'autre. En effet, les objets portables auxquels il est fait ici référence tels que des montres-bracelets sont produits en grandes quantités à une échelle industrielle. Il est donc nécessaire de prendre des dispositions pour garantir la meilleure reproductibilité possible de la mesure de l'induction magnétique d'un objet à l'autre, sans toutefois que ces dispositions ne grèvent trop le prix de revient final de l'objet portable. Or, pour garantir une bonne reproductibilité d'une mesure d'induction magnétique, il faut pouvoir garantir le bon positionnement relatif de l'aimant et du capteur inductif.

### Résumé de l'invention

La présente invention a pour but de pallier les problèmes mentionnés ci-dessus ainsi que d'autres encore en procurant un objet portable comprenant une tige rotative pour la commande d'au moins une fonction mécanique ou électronique de cet objet portable, l'actionnement de la tige rotative étant détectée de manière fiable et reproductible au moyen d'un capteur inductif.

A cet effet, la présente invention concerne un objet portable comprenant un bâti agencé pour servir de berceau à une tige de commande rotative dont l'actionnement permet de commander au moins une fonction électronique ou mécanique de l'objet portable, un anneau aimanté étant entraîné en rotation par la tige de commande rotative, la rotation de l'anneau aimanté étant détectée par au moins un capteur inductif maintenu en appui contre une surface du bâti.

Par capteur inductif, on entend un capteur qui transforme un champ magnétique qui le traverse en tension électrique grâce au phénomène d'induction défini par la loi de Lenz-Faraday. A titre d'exemple, il peut s'agir d'un capteur à effet Hall ou bien encore d'un composant magnétorésistif de type AMR (Anisostropic Magnetoresistance), GMR (Giant Magnetoresistance) ou TMR (Tunneling Magnetoresistance).

Grâce à ces caractéristiques, la présente invention procure un objet portable dans lequel la détection de la rotation d'une tige de commande d'au moins une fonction mécanique ou électronique de cet objet portable est obtenue par mesure de la variation de l'induction magnétique engendrée par la rotation d'un anneau aimanté entraîné par la tige de commande au moyen d'un capteur inductif. Ce capteur est maintenu en appui contre une surface d'un bâti de l'objet portable. Ainsi, la précision de l'agencement relatif de l'anneau aimanté et du capteur inductif est déterminée uniquement par la précision avec laquelle est fabriqué le bâti. En effet, l'anneau aimanté est entraîné par la tige de commande qui elle-même est portée par le bâti, et le capteur inductif est maintenu en appui contre une surface du bâti. Or, le bâti est typiquement réalisé par injection d'un matériau plastique avec une très bonne précision. Par conséquent, la précision de l'agencement relatif de l'aimant et du capteur à effet Hall est très satisfaisante et surtout pleinement reproductible d'un objet portable à l'autre, même dans des conditions d'une production de masse, ce qui est tout à fait remarquable.

Conformément à d'autres caractéristiques de l'invention qui font l'objet des revendications dépendantes :
- le capteur inductif est disposé dans un logement du bâti de l'objet portable dans lequel il est maintenu par des moyens élastiques ;
- l'objet portable comprend une plaque de maintien munie d'un doigt élastique qui, par pression sur le capteur inductif, maintient ce capteur inductif à l'intérieur du logement dans lequel il est disposé ;
- le capteur inductif est fixé sur une feuille de circuit imprimé flexible et le doigt élastique appuie sur cette feuille de circuit imprimé flexible à l'endroit où le capteur inductif est fixé :
- le doigt élastique garantit l'immobilisation du capteur inductif selon une direction verticale ;
- le doigt élastique est agencé pour forcer le capteur inductif contre un fond du logement dans lequel il est disposé ;
- l'objet portable comprend deux capteurs inductifs qui sont agencés de part et d'autre d'un plan vertical de symétrie longitudinale de la tige de commande ;
- les deux capteurs inductifs sont agencés par rapport à la tige de commande rotative de façon que, lorsque l'anneau aimanté tourne sous l'effet de l'actionnement de la tige de commande rotative, les deux capteurs inductifs produisent des signaux qui sont déphasés l'un par rapport à l'autre d'un angle compris entre 60° et 120°.

Grâce à ces autres caractéristiques, le capteur inductif est maintenu par des moyens élastiques dans le logement du bâti à l'intérieur duquel il est disposé, ce qui permet de rattraper d'éventuels jeux et donc de garantir un positionnement précis et reproductible entre l'aimant et le capteur inductif.

### Brève description des figures

D'autres caractéristiques et avantages de la présente invention ressortiront plus clairement de la description détaillée qui suit d'un exemple de réalisation d'un objet portable selon l'invention, cet exemple étant donné à titre purement illustratif et non limitatif seulement en liaison avec le dessin annexé sur lequel :
- la figure 1 est une vue en perspective à l'état dissocié d'un dispositif de commande d'au moins une fonction électronique d'un objet portable de petites dimensions ;
- la figure 2 est une vue de dessus en perspective du bâti inférieur ;
- la figure 3 est une vue en perspective de la tige de commande qui, de la droite vers la gauche de la figure, s'étend depuis son extrémité arrière vers son extrémité avant ;
- la figure 4 est une vue en perspective et à l'état dissocié du palier lisse et de l'équipage magnétique formé d'une bague support et d'un anneau aimanté;
- la figure 5 est une vue en coupe longitudinale selon un plan vertical d'un dispositif de commande à l'intérieur duquel sont notamment agencés le palier lisse et l'équipage magnétique formé de la bague support et de l'anneau aimanté;
- la figure 6 est une vue de dessous en perspective du bâti supérieur ;
- la figure 7A est une vue de dessus en perspective de la plaque d'indexation de position de la tige de commande ;
- la figure 7B est une vue à plus grande échelle de la zone entourée d'un cercle sur la figure 7A ;
- la figure 8 est une vue en perspective du ressort de positionnement agencé pour coopérer avec la plaque d'indexation de la position de la tige de commande ;
- la figure 9 est une vue de dessus en perspective du ressort de limitation du déplacement de la plaque d'indexation de la position de la tige de commande ;
- la figure 10 est une vue en perspective de la plaque de déboîtement ;
- la figure 11 est une vue en coupe longitudinale d'une partie du dispositif de commande sur laquelle est visible le trou dans lequel est introduit un outil pointu pour libérer la tige de commande de la plaque d'indexation de position ;
- la figure 12A est une vue en perspective sur laquelle est visible la tige de commande coopérant avec la plaque d'indexation de la position et le ressort de positionnement, la tige de commande étant en position stable T1 ;
- la figure 12B est une vue analogue à celle de la figure 12A, la tige de commande étant en position poussée instable T0 ;
- la figure 12C est une vue analogue à celle de la figure 12A, la tige de commande étant en position tirée stable T2 ;
- la figure 13 est une vue en perspective des ressorts de contact T0 et T2 ;
- les figures 14A et 14B sont des vues schématiques qui illustrent la coopération entre les doigts de la plaque d'indexation de la position de la tige de commande et les ressorts de contact T2 ;
- la figure 15 est une vue partielle en perspective de la feuille de circuit imprimé flexible sur laquelle sont ménagées les plages de contact des ressorts de contact T0 et T2 ;
- la figure 16 est une vue en perspective de la portion libre de la feuille de circuit imprimé flexible sur laquelle sont fixés les capteurs inductifs ;
- la figure 17A est une vue en perspective du dispositif de commande sur une face arrière duquel la portion libre de la feuille de circuit imprimé flexible est repliée ;
- la figure 17B est une vue en perspective du dispositif de commande sur une face arrière duquel la portion libre de circuit imprimé flexible est repliée et maintenue au moyen d'une plaque de maintien fixée par des vis sur le dispositif de commande ;
- la figure 18 est une vue en élévation du système de détection de la position de l'anneau aimanté au moyen de deux capteurs inductifs ;
- la figure 19 est une vue en élévation du système de détection de la rotation de l'anneau aimanté au moyen d'un capteur inductif unique ;
- la figure 20 est une vue en perspective du dispositif de commande installé dans un objet portable ;
- la figure 21 est une vue analogue à celle de la figure 20, la tige de commande étant extraite de l'objet portable ;
- la figure 22 est une représentation schématique d'un mode simplifié de fixation des capteurs inductifs au fond de leurs logements dans le bâti, et
- la figure 23 illustre le cas dans lequel les capteurs inductifs sont simplement maintenus en appui contre une surface d'appui du bâti.

### Description détaillée d'un mode de réalisation de l'invention

La présente invention procède de l'idée générale inventive qui consiste à détecter la rotation d'une tige de commande montée dans un objet portable de petites dimensions tel qu'une pièce d'horlogerie de manière fiable et reproductible d'un objet portable à l'autre, en particulier dans le cas d'une fabrication de masse. Pour résoudre ce problème, on utilise un anneau aimanté de préférence bipolaire, mais qui peut également être multipolaire. Cet anneau aimanté est entraîné en rotation par la tige de commande et on détecte la variation de l'induction magnétique engendrée par la rotation de l'anneau aimanté au moyen d'un capteur inductif. Pour garantir la reproductibilité de la mesure d'un objet portable à l'autre, l'invention enseigne d'utiliser un bâti qui sert de berceau à la tige de commande et contre une surface duquel le capteur inductif est maintenu en appui. La précision du positionnement de l'anneau aimanté et du capteur inductif est donc déterminée par la précision de fabrication du bâti. Dans le cas où le bâti est par exemple réalisé par injection d'un matériau plastique ou bien en un matériau métallique amagnétique tel que du laiton, cette précision est excellente et permet donc de garantir la reproductibilité de la mesure d'un objet à l'autre, mêmes dans des conditions de fabrication industrielles en grandes séries. De plus, du fait que, dans une variante préférée de réalisation de l'invention, le capteur inductif est maintenu dans son logement par des moyens élastiques, cela permet de rattraper d'éventuels jeux.

Dans tout ce qui suit, la direction d'arrière en avant est une direction rectiligne qui s'étend horizontalement le long de l'axe longitudinal de symétrie X-X de la tige de commande depuis la couronne extérieure d'actionnement vers l'intérieur de l'objet portable équipé du dispositif de commande. Ainsi, la tige de commande sera poussée de l'arrière vers l'avant, et sera tirée de l'avant vers l'arrière. Par ailleurs, la direction verticale z est une direction qui s'étend perpendiculairement au plan dans lequel s'étend la tige de commande.

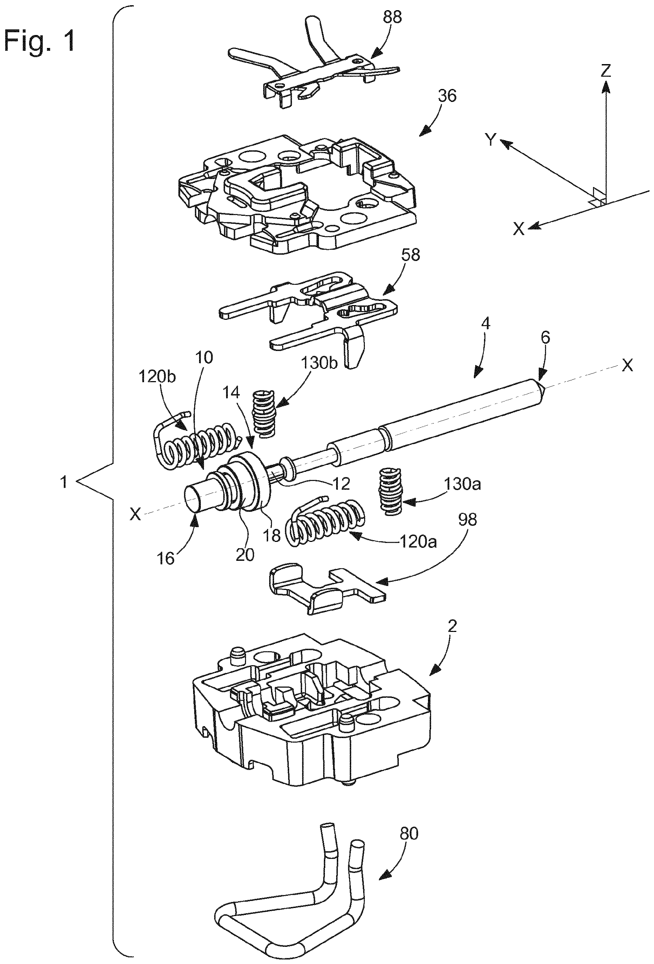

La figure 1 est une vue en perspective à l'état dissocié d'un dispositif pour la commande d'au moins une fonction électronique d'un objet portable de petites dimensions comme une montre-bracelet. Désigné dans son ensemble par la référence numérique générale 1, ce dispositif de commande comprend un bâti inférieur 2, par exemple réalisé en un matériau plastique injecté ou en un matériau métallique amagnétique tel que du laiton, et sert de berceau à une tige de commande 4 de forme préférentiellement allongée et sensiblement cylindrique, dotée d'un axe longitudinal de symétrie X-X. Cette tige de commande 4 est agencée pour coulisser d'avant en arrière et d'arrière en avant le long de son axe longitudinal de symétrie X-X, et/ou pour tourner autour de ce même axe longitudinal de symétrie X-X dans le sens horaire et antihoraire.

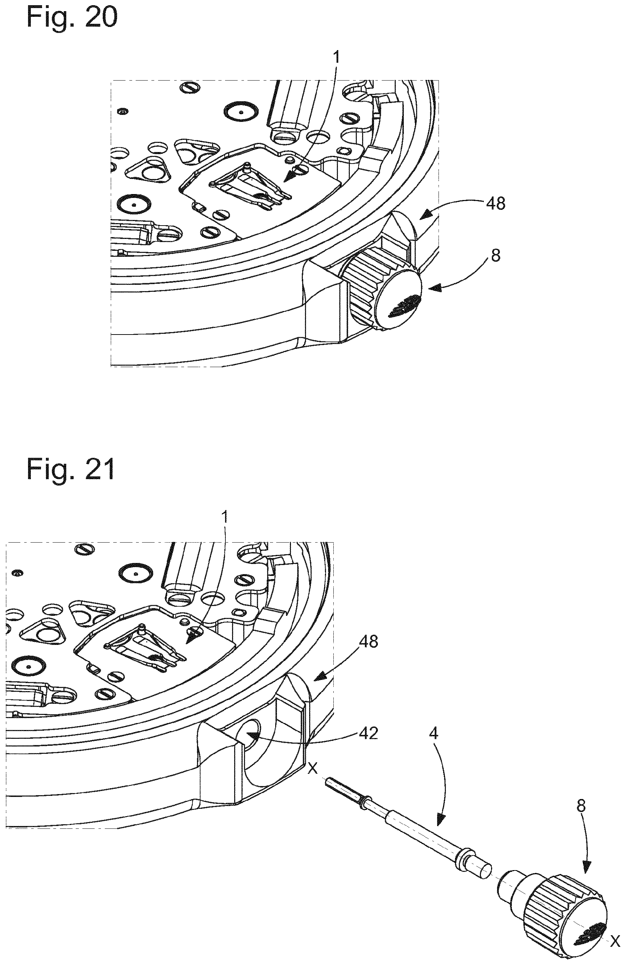

A une extrémité arrière 6 qui sera située à l'extérieur de l'objet portable une fois celui-ci équipé d'un dispositif de commande 1, la tige de commande 4 recevra une couronne d'actionnement 8 (voir figure 20).

A une extrémité avant 10 qui sera située à l'intérieur du dispositif de commande 1 une fois celui-ci assemblé, la tige de commande 4 présente une section 12 par exemple carrée et reçoit successivement un équipage magnétique 14 et un palier lisse 16.

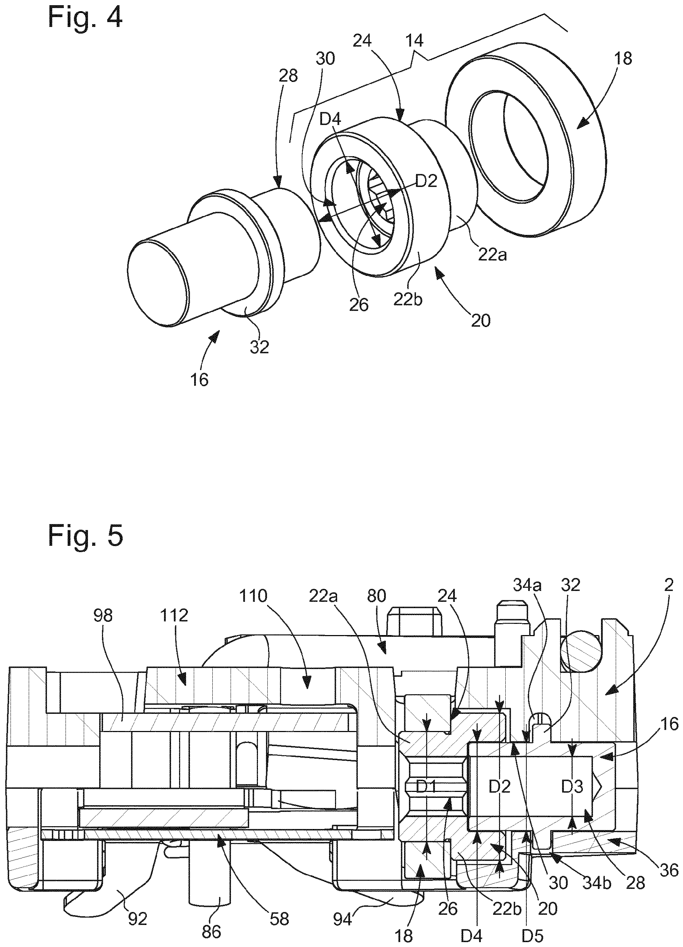

L'équipage magnétique 14 comprend un anneau aimanté 18 et une bague-support 20 sur laquelle l'anneau aimanté 18 est fixé typiquement par collage (voir figure 4). La bague-support 20 est une pièce de forme générale cylindrique. Comme visible sur la figure 5, la bague-support 20 présente, de l'arrière vers l'avant, une première section 22a d'un premier diamètre extérieur D1 sur laquelle est engagé l'anneau aimanté 18, et une seconde section 22b d'un deuxième diamètre extérieur D2 supérieur au premier diamètre extérieur D1 et qui délimite un épaulement 24 contre lequel l'anneau aimanté 18 vient en appui. La première section 22a de la bague-support 20 est percée d'un trou carré 26 qui est adapté en forme et en dimension à la section carrée 12 de la tige de commande 4 et forme avec cette tige de commande 4 un système du type pignon coulant. En d'autres termes, la bague-support 20 et l'anneau aimanté 18 restent immobiles lorsque l'on fait coulisser axialement la tige de commande 4. Par contre, la tige de commande 4 entraîne la bague-support 20 et l'anneau aimanté 18 en rotation lorsqu'on fait tourner cette tige de commande 4. On comprend de ce qui précède que l'anneau aimanté 18, porté par la bague-support 20, n'est pas en contact avec la tige de commande 4, ce qui permet de le protéger en cas de chocs appliqués sur l'objet portable équipé d'un dispositif de commande 1.

Le palier lisse 16 définit (voir figure 5) un logement cylindrique 28 dont le premier diamètre intérieur D3 est très légèrement supérieur au diamètre du cercle dans lequel s'inscrit la section carrée 12 de la tige de commande 4 afin de permettre à cette tige de commande 4 de coulisser axialement et/ou de tourner à l'intérieur de ce logement cylindrique 28. Le palier lisse 16 garantit ainsi le parfait guidage axial de la tige de commande 4.

On remarque que le trou carré 26 ménagé dans la première section 22a de la bague-support 20 est prolongé vers l'avant du dispositif de commande 1 par un trou annulaire 30 dont le second diamètre intérieur D4 est ajusté sur le troisième diamètre extérieur D5 du palier lisse 16. La bague-support 20 est ainsi enfilée libre en rotation sur le palier lisse 16 et vient en butée axiale contre ce palier lisse 16, ce qui garantit le parfait alignement axial de ces deux pièces et permet de corriger les éventuels problèmes de concentricité que peut poser un accouplement du type pignon coulant.

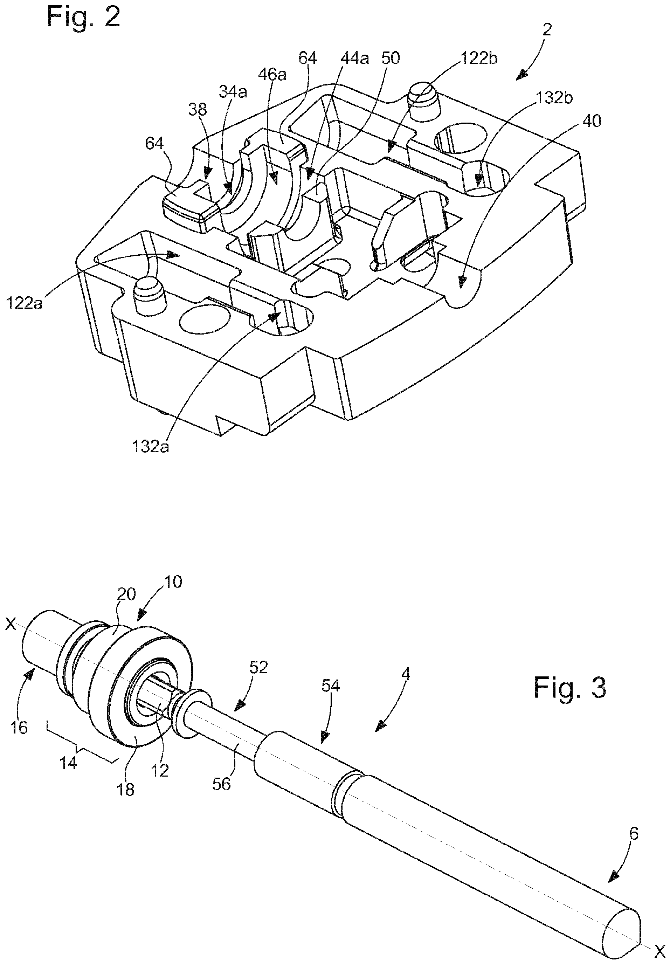

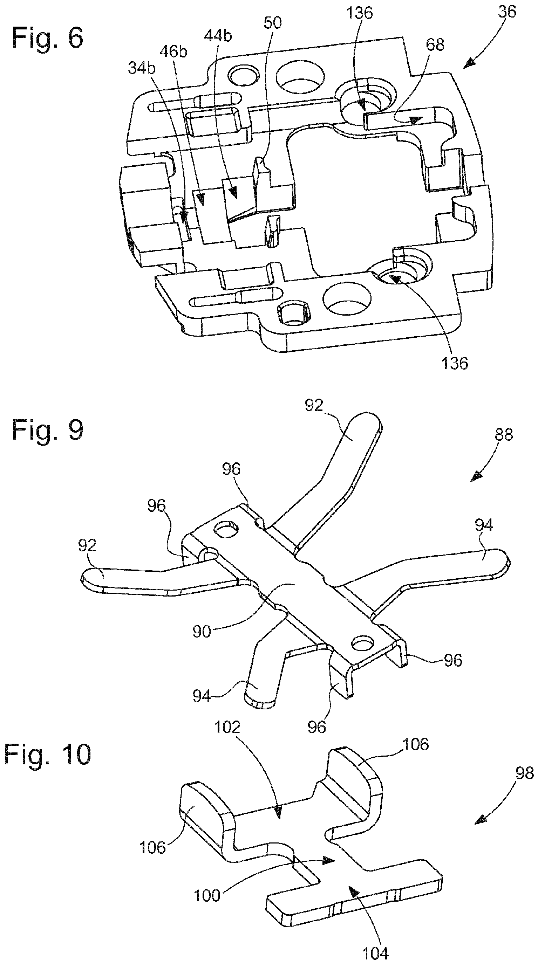

On observe que, pour son immobilisation axiale, le palier lisse 16 est muni sur sa surface extérieure d'une collerette circulaire 32 qui fait saillie dans une première gorge 34a et dans une seconde gorge 34b ménagées respectivement dans le bâti inférieur 2 (voir figure 2) et dans un bâti supérieur 36 (voir figure 6) agencé pour coiffer le bâti inférieur 2 et par exemple réalisé en un matériau plastique injecté ou en un matériau métallique amagnétique. Ces deux bâtis inférieur 2 et supérieur 36 seront décrits en détail ultérieurement.

Il est important de noter que l'équipage magnétique 14 et le palier lisse 16 décrits ci-dessus sont indiqués à titre purement illustratif seulement. En effet, le palier lisse 16, par exemple réalisé en acier ou en laiton, est prévu pour éviter que la tige de commande 4, par exemple réalisée en acier, ne frotte contre les bâtis inférieur 2 et supérieur 36 et provoque une usure du matériau plastique dans lequel ces deux bâtis inférieur 2 et supérieur 36 sont typiquement réalisés. Toutefois, dans un mode simplifié, on peut très bien envisager de ne pas utiliser un tel palier lisse 16 et prévoir que la tige de commande 4 soit directement portée par le bâti inférieur 2.

De même, l'anneau aimanté 18 et la bague-support 20 sur laquelle l'anneau aimanté 18 est fixé sont prévus pour le cas où l'on détecte la rotation de la tige de commande 4 par une variation locale du champ magnétique induite par le pivotement de l'anneau aimanté 18. Il est cependant tout à fait envisageable de remplacer l'équipage magnétique 14 par exemple par un pignon coulant qui, suivant sa position, va par exemple commander le remontage d'un ressort de barillet ou la mise à l'heure d'une montre équipée du dispositif de commande 1.

Il est aussi important de noter que l'exemple de la tige de commande 4 munie sur une partie de sa longueur d'une section carrée est donné à titre purement illustratif seulement. En effet, pour entraîner l'équipage magnétique 14 en rotation, la tige de commande 4 peut présenter tout type de section qui s'écarte d'une section circulaire, par exemple triangulaire ou ovale.

Le bâti inférieur 2 et le bâti supérieur 36 dont la réunion définit la géométrie extérieure du dispositif de commande 1 sont par exemple de forme générale parallélépipédique. Le bâti inférieur 2 forme un berceau qui reçoit la tige de commande 4. A cet effet (voir figure 2), le bâti inférieur 2 comprend vers l'avant une première surface de réception 38 de profil semi-circulaire qui sert de siège au palier lisse 16 et dans laquelle est ménagée la première gorge 34a qui reçoit la collerette circulaire 32. L'immobilisation du palier lisse 16 tant axialement qu'en rotation est ainsi assurée.

Le bâti inférieur 2 comprend d'autre part vers l'arrière une deuxième surface de réception 40 dont le profil semi-circulaire est centré sur l'axe longitudinal de symétrie X-X de la tige de commande 4, mais dont le diamètre est supérieur à celui de cette tige de commande 4. Il est important de bien comprendre que la tige de commande 4 ne prend appui sur la deuxième surface de réception 40 qu'au stade où le dispositif de commande 1, assemblé, est testé avant d'être intégré dans l'objet portable. A ce stade du montage, la tige de commande 4 est introduite dans le dispositif de commande 1 à des fins de test et s'étend horizontalement en étant supportée et guidée axialement par le palier lisse 16 du côté de son extrémité avant 10 et par la deuxième surface de réception 40 du côté de son extrémité arrière 6. Par contre, une fois le dispositif de commande 1 intégré dans l'objet portable, la tige de commande 4 passe à travers un trou 42 ménagé dans la carrure 48 de l'objet portable dans lequel elle est guidée et supportée (voir figure 21).

Des troisième et quatrième surfaces de dégagement 44a et 46a de profil semi-circulaire sont également prévues dans le bâti inférieur 2 et des surfaces de dégagement complémentaires 44b et 46b (voir figure 6) sont prévues dans le bâti supérieur 36 pour recevoir l'équipage magnétique 14 constitué de l'anneau aimanté 18 et de sa bague-support 20. On notera que l'anneau aimanté 18 et sa bague-support 20 ne sont pas en contact avec les troisième et quatrième surfaces de dégagement 44a, 46a et les surfaces de dégagement complémentaires 44b et 46b lorsque le dispositif de commande 1 est assemblé et monté dans l'objet portable. On note également que la troisième surface de dégagement 44a et sa surface de dégagement complémentaire 44b correspondante sont délimitées par une collerette annulaire 50 pour le blocage axial de l'équipage magnétique 14.

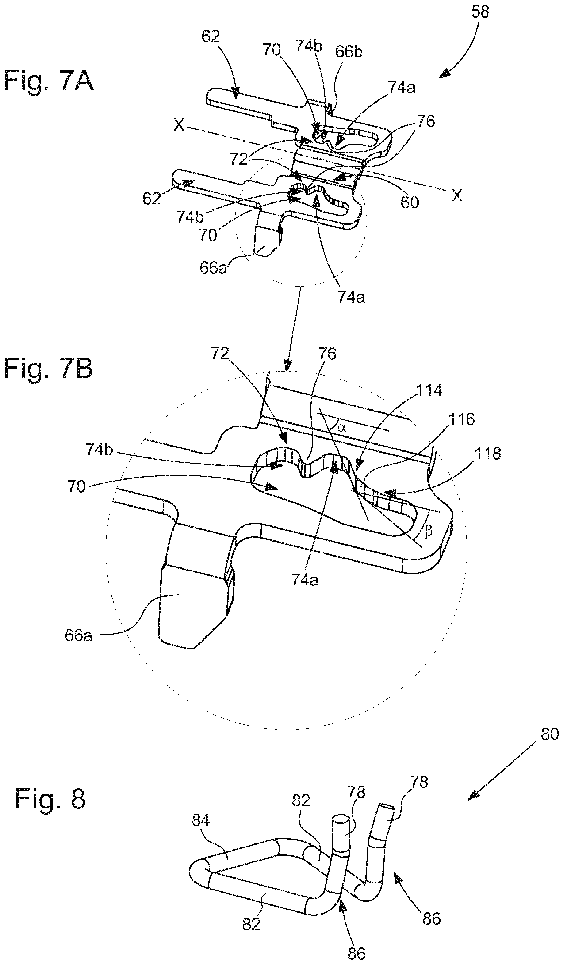

Comme visible sur la figure 3, en arrière de la section carrée 12, la tige de commande 4 présente une section cylindrique 52 dont le diamètre est compris entre le diamètre du cercle dans lequel s'inscrit la section carrée 12 de la tige de commande 4 et le diamètre primitif d'une section arrière 54 de cette même tige de commande 4 à l'extrémité de laquelle est fixée la couronne d'actionnement 8. Cette section cylindrique 52 de diamètre réduit forme une rainure 56 dans laquelle est posée une plaque 58 d'indexation de la position de la tige de commande 4 (voir figure 7A). A cet effet, la plaque d'indexation de position 58 présente une portion courbée 60 qui épouse le profil de la section cylindrique 52 de diamètre réduit. La plaque d'indexation de position 58 peut être par exemple obtenue par étampage d'une tôle métallique fine conductrice de l'électricité. Mais il est également envisageable de réaliser cette plaque d'indexation de position 58 par exemple par moulage d'un matériau plastique dur chargé avec des particules conductrices. L'engagement de la plaque d'indexation de position 58 dans la rainure 56 garantit le couplage en translation d'avant en arrière et d'arrière en avant entre la tige de commande 4 et la plaque d'indexation de position 58. Par contre, comme on le comprendra mieux ultérieurement, la plaque d'indexation de position 58 est libre par rapport à la tige de commande 4 selon une direction verticale z perpendiculaire à l'axe longitudinal de symétrie X-X de la tige de commande 4.

Comme visible sur la figure 7A, la plaque d'indexation de position 58 est une pièce sensiblement plane et de forme générale en U. Cette plaque d'indexation de position 58 comprend deux bras de guidage 62 sensiblement rectilignes qui s'étendent parallèlement entre eux et qui sont reliés l'un à l'autre par la portion courbée 60. Ces deux bras de guidage 62 sont guidés axialement par exemple contre deux plots 64 ménagés dans le bâti inférieur 2 (voir notamment figure 2). Guidée par ses deux bras de guidage 62, la plaque d'indexation de position 58 glisse le long d'un rebord 68 ménagé dans le bâti supérieur 36 et dont le périmètre correspond à celui de la plaque d'indexation de position 58 (voir figure 6). La plaque d'indexation de position 58 comprend également deux doigts 66a, 66b qui s'étendent verticalement vers le bas de part et d'autre des deux bras de guidage 62. En glissant le long du rebord 68, la plaque d'indexation de position 58 a notamment pour fonction d'assurer le guidage en translation de la tige de commande 4 d'avant en arrière et d'arrière en avant. Quant aux doigts 66a, 66b, ils permettent en particulier d'empêcher que la plaque d'indexation de position 58 ne s'arc-boute lorsque celle-ci se déplace en translation.

Deux ouvertures 70 présentant un contour approximativement rectangulaire sont ménagées dans les bras de guidage 62 de la plaque d'indexation de position 58 (voir en particulier la figure 7B). Ces deux ouvertures 70 s'étendent symétriquement de part et d'autre de l'axe longitudinal de symétrie X-X de la tige de commande 4. Les côtés des deux ouvertures 70 les plus proches de l'axe longitudinal de symétrie X-X de la tige de commande 4 présentent un profil 72 de forme sensiblement sinusoïdale formé d'un premier et d'un second creux 74a et 74b séparés par un sommet 76.

Les deux ouvertures 70 ménagées dans les bras de guidage 62 sont destinées à recevoir les deux extrémités 78 d'un ressort de positionnement 80 (voir figure 8). Ce ressort de positionnement 80 a une forme générale en U avec deux bras 82 qui s'étendent dans un plan horizontal et qui sont reliés entre eux par une base 84. A leur extrémité libre, les deux bras 82 sont prolongés par deux tiges 86 sensiblement rectilignes qui se dressent verticalement. Le ressort de positionnement 80 est destiné à être monté dans le dispositif de commande 1 par le dessous du bâti inférieur 2, de sorte que les extrémités 78 des tiges 86 viennent faire saillie dans les ouvertures 70 de la plaque d'indexation de position 58. On verra ci-dessous que la coopération entre la plaque d'indexation de position 58 et le ressort de positionnement 80 permet d'indexer la position de la tige de commande 4 entre une position poussée instable T0 et deux positions stables T1 et T2.

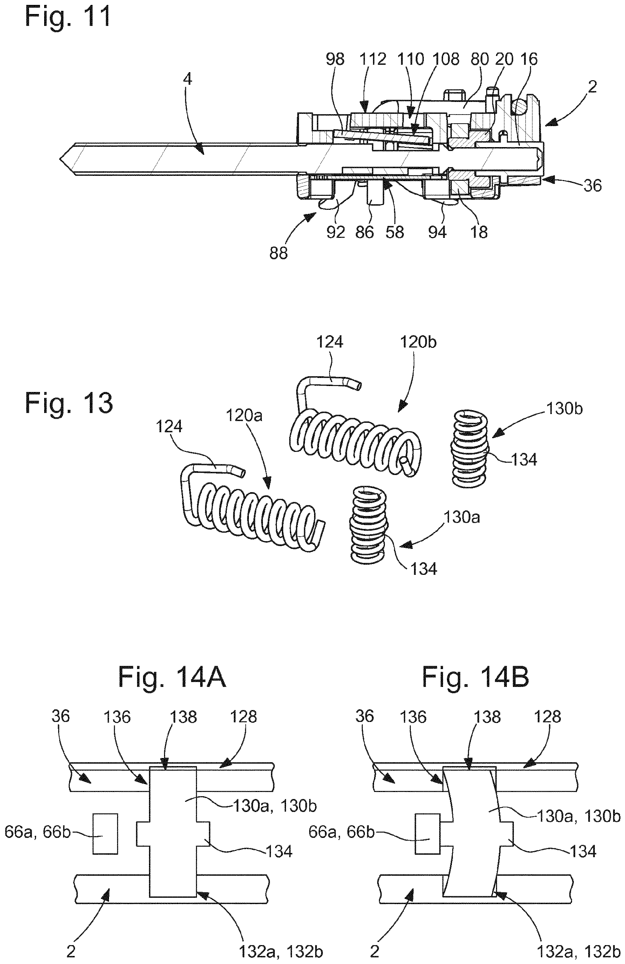

On a mentionné ci-dessus que la plaque d'indexation de position 58 est couplée en translation avec la tige de commande 4, mais qu'elle est libre par rapport à la tige de commande 4 selon la direction verticale z. Il est donc nécessaire de prendre des mesures pour empêcher la plaque d'indexation de position 58 de se désengager de la tige de commande 4 en conditions normales d'utilisation, par exemple sous l'effet de la pesanteur. A cet effet (voir figures 9 et 11), on dispose un ressort 88 de limitation du déplacement de la plaque d'indexation de position 58 selon la direction verticale z au-dessus et à faible distance de cette plaque d'indexation de position 58. Le ressort de limitation du déplacement 88 est emprisonné entre le bâti inférieur 2 et le bâti supérieur 36 du dispositif de commande 1, mais n'est pas, en conditions normales d'utilisation, en contact avec la plaque d'indexation de position 58, ce qui permet d'éviter que ne s'exercent des forces de frottement parasites sur la tige de commande 4 qui rendraient sa manipulation malaisée et provoqueraient un phénomène d'usure. Le ressort de limitation du déplacement 88 est cependant suffisamment proche de la plaque d'indexation de position 58 pour que celle-ci ne puisse se découpler de la tige de commande 4 de manière intempestive.

Le ressort de limitation du déplacement 88 comprend une partie centrale 90 sensiblement rectiligne à partir des extrémités de laquelle s'étendent deux paires de bras élastiques 92 et 94. Ces bras élastiques 92 et 94 s'étendent de part et d'autre de la partie centrale 90 du ressort de limitation du déplacement 88, en s'éloignant vers le haut du plan horizontal dans lequel s'étend cette partie centrale 90. Ces bras élastiques 92 et 94, en étant comprimés lorsque le bâti supérieur 36 est joint au bâti inférieur 2, confèrent au ressort de limitation du déplacement 88 son élasticité suivant la direction verticale z. Entre les paires de bras élastiques 92 et 94 est également prévue une paire et, préférentiellement, deux paires de pattes rigides 96 qui s'étendent perpendiculairement vers le bas de part et d'autre de la partie centrale 90 du ressort de limitation de déplacement 88. Ces pattes rigides 96 qui viennent en appui sur le bâti inférieur 2 lorsque le bâti supérieur 36 est posé sur le bâti inférieur 2, garantissent le respect d'un espacement minimum entre la plaque d'indexation de position 58 et le ressort de limitation du déplacement 88 en conditions normales de fonctionnement du dispositif de commande 1.

Le ressort de limitation du déplacement 88 garantit le caractère démontable du dispositif de commande 1. En effet, en l'absence du ressort de limitation de déplacement 88, la plaque d'indexation de position 58 devrait être solidaire de la tige de commande 4 et, par suite, la tige de commande 4 ne pourrait plus être démontée. Or, si la tige de commande 4 ne peut être démontée, le mouvement de la pièce d'horlogerie équipée du dispositif de commande 1 est lui aussi indémontable, ce qui n'est pas envisageable notamment dans le cas d'une pièce d'horlogerie coûteuse. Ainsi, lorsque le dispositif de commande 1, formé par la réunion des bâtis inférieur 2 et supérieur 36, est monté dans l'objet portable et que l'on insère la tige de commande 4 dans le dispositif de commande 1 depuis l'extérieur de l'objet portable, la tige de commande 4 soulève légèrement la plaque d'indexation de position 58 à l'encontre de la force élastique du ressort de limitation du déplacement 88. En continuant de pousser en avant la tige de commande 4, arrive un moment où la plaque d'indexation de position 58 tombe dans la rainure 56 sous l'effet de la gravité. La tige de commande 4 et la plaque d'indexation de position 58 sont alors couplées en translation.

Une plaque de déboîtement 98 est prévue pour permettre le démontage de la tige de commande 4 (voir figure 10). Cette plaque de déboîtement 98 est de forme générale en H et comprend un segment droit 100 qui s'étend parallèlement à l'axe longitudinal de symétrie X-X de la tige de commande 4 et auquel se rattachent une première et une seconde section transversale 102 et 104. La première section transversale 102 est en outre munie à ses deux extrémités libres de deux pattes 106 repliées à angle sensiblement droit. La plaque de déboîtement 98 est reçue dans un logement 108 ménagé dans le bâti inférieur 2 et situé sous la tige de commande 4. Ce logement 108 communique avec l'extérieur du dispositif de commande 1 via un trou 110 qui débouche dans une face inférieure 112 du dispositif de commande 1 (voir figure 11). En introduisant un outil pointu dans le trou 110, on peut exercer une poussée sur la plaque de déboîtement 98 qui, via ses deux pattes 106, pousse à son tour la plaque d'indexation de position 58 à l'encontre de la force élastique du ressort de limitation du déplacement 88. La plaque d'indexation de position 58 sort alors de la rainure 56 ménagée dans la tige de commande 4 et il suffit d'exercer une légère traction vers l'arrière sur la tige de commande 4 pour pouvoir extraire celle-ci du dispositif de commande 1.

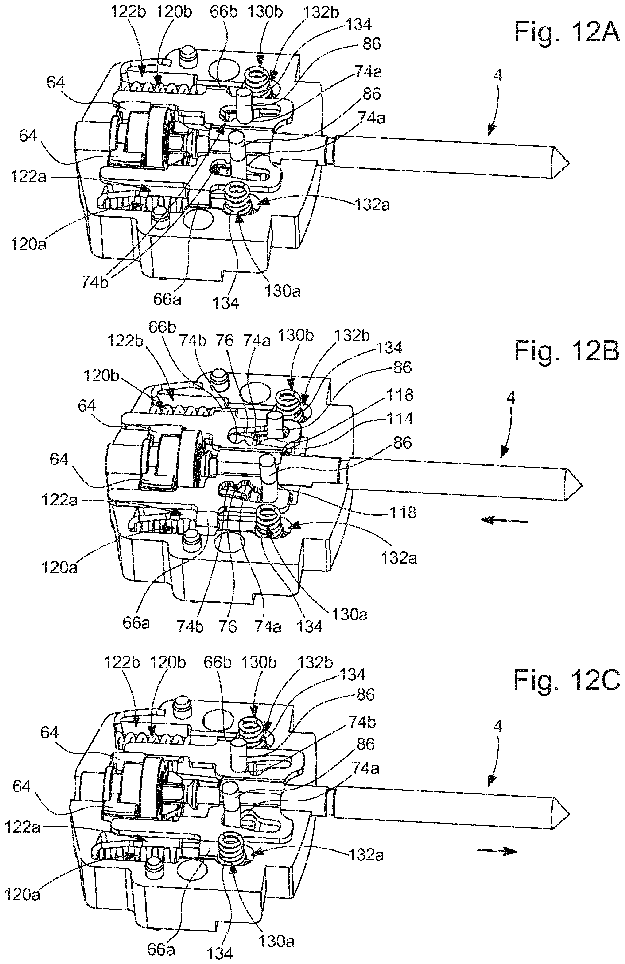

Depuis sa position stable de repos T1, la tige de commande 4 peut être poussée vers l'avant dans une position instable T0 ou tirée dans une position stable T2. Ces trois positions T0, T1 et T2 de la tige de commande 4 sont indexées par coopération entre la plaque d'indexation de position 58 et le ressort de positionnement 80. Plus précisément (voir figure 12A), la position stable de repos T1 dans laquelle aucune commande ne peut être introduite dans l'objet portable équipé du dispositif de commande 1 correspond à la position dans laquelle les extrémités 78 des tiges 86 du ressort de positionnement 80 font saillie dans les premiers creux 74a des deux ouvertures 70 ménagées dans les bras de guidage 62 de la plaque d'indexation de position 58. Depuis cette position stable de repos T1, la tige de commande 4 peut être poussée en avant dans une position instable T0 (voir figure 12B). Durant ce déplacement, les extrémités 78 des tiges 86 du ressort de positionnement 80 sortent des premiers creux 74a et suivent un premier profil en rampe 114 qui s'écarte progressivement de l'axe longitudinal de symétrie X-X de la tige de commande 4 selon une première pente α abrupte (voir figure 7B). Pour forcer les extrémités 78 des tiges 86 du ressort de positionnement 80 à sortir des premiers creux 74a et à s'engager sur le premier profil en rampe 114 en s'écartant l'une de l'autre, l'utilisateur doit donc vaincre un effort résistant significatif.

Arrivées à un point de transition 116, les extrémités 78 des tiges 86 s'engagent sur un second profil en rampe 118 qui prolonge le premier profil en rampe 114 avec une seconde pente β inférieure à la première pente α du premier profil en rampe 114. A l'instant où les extrémités 78 des tiges 86 du ressort de positionnement 80 franchissent le point de transition 116 et s'engagent sur le second profil en rampe 118, l'effort que l'utilisateur doit fournir pour continuer à faire avancer la tige de commande 4 chute brutalement et l'utilisateur ressent un déclic qui lui indique la transition de la tige de commande 4 entre sa position T1 et sa position T0. En suivant le second profil en rampe 118, les tiges 86 du ressort de positionnement 80 continuent à s'écarter légèrement de leur position de repos et tendent à vouloir à nouveau se rapprocher l'une de l'autre sous l'effet de leur force élastique de rappel opposée à la force de poussée exercée par l'utilisateur sur la tige de commande 4. Aussitôt que l'utilisateur relâche sa pression sur la tige de commande 4, les tiges 86 du ressort de positionnement 80 vont spontanément redescendre le long du premier profil en rampe 114 et leurs extrémités 78 vont à nouveau venir se loger dans les premiers creux 74a des deux ouvertures 70 ménagées dans les bras de guidage 62 de la plaque d'indexation de position 58. La tige de commande 4 est ainsi automatiquement rappelée de sa position instable T0 à sa première position stable T1.

Des premier et deuxième ressorts de contact 120a et 120b sont logés comprimés dans une première et une deuxième cavité 122a et 122b ménagées dans le bâti inférieur 2. Ces premier et deuxième ressorts de contact 120a et 120b peuvent être au choix des ressorts de contact hélicoïdaux, des lames ressorts ou autres. Les deux cavités 122a, 122b s'étendent préférentiellement mais non obligatoirement horizontalement. Du fait que les deux ressorts de contact 120a, 120b sont installés à l'état comprimé, la précision de leur positionnement est conditionnée par la tolérance avec laquelle est fabriqué le bâti inférieur 2. Or, la précision avec laquelle est fabriqué le bâti inférieur 2 est supérieure à la précision de fabrication de ces premier et deuxième ressorts de contact 120a, 120b. Par conséquent, la précision avec laquelle la position T0 de la tige de commande 4 est détectée est élevée.

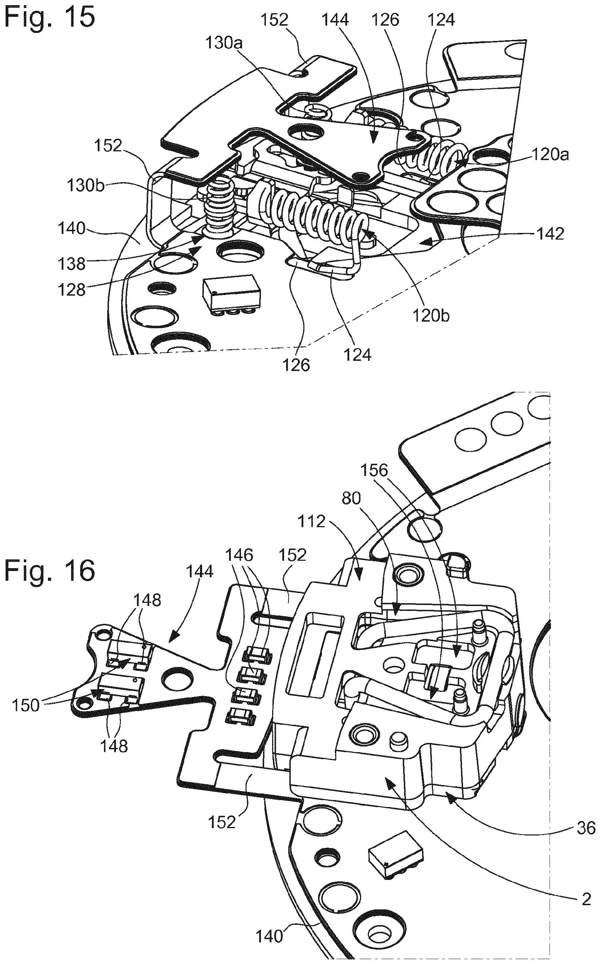

Comme visible sur les figures 13 et 15, l'une des extrémités des premier et deuxième ressorts de contact 120a, 120b est recourbée de manière à former deux pattes de contact 124 qui vont venir s'appuyer sur deux premières plages de contact 126 correspondantes prévues à la surface d'une feuille de circuit imprimé flexible 128. Le moment où les extrémités 78 des tiges 86 du ressort de positionnement 80 s'engagent sur le second profil en rampe 118 des deux ouvertures 70 ménagées dans la plaque d'indexation de position 58 coïncide avec le moment où les doigts 66a, 66b de la plaque d'indexation de position 58 viennent en contact avec les premier et deuxième ressorts de contact 120a, 120b. Comme cette plaque d'indexation de position 58 est électriquement conductrice, lorsque les doigts 66a, 66b viennent en contact avec les premier et deuxième ressorts de contact 120a, 120b, le courant électrique passe à travers la plaque d'indexation de position 58 et l'on détecte la fermeture du contact électrique entre les premier et deuxième ressorts de contact 120a, 120b.

Les premier et deuxième ressorts de contact 120a, 120b sont de même longueur. Cependant, de manière préférée, la première cavité 122a sera par exemple plus longue que la deuxième cavité 122b notamment pour tenir compte des problèmes de tolérance (la différence de longueur entre les deux cavités 122a, 122b est de quelques dixièmes de millimètre). De cette manière, lorsqu'on pousse la tige de commande 4 en avant dans sa position T0, le doigt 66a de la plaque d'indexation de position 58 qui se trouve en correspondance avec le premier ressort de contact 120a logé dans la première cavité 122a la plus longue va venir en contact avec ce dernier et commencer à le comprimer. La tige de commande 4 va continuer à avancer et le second doigt 66b de la plaque d'indexation de position 58 va venir en contact avec le deuxième ressort de contact 120b logé dans la deuxième cavité 122b la plus courte. A ce moment-là, la plaque d'indexation de position 58 va se trouver en contact avec les premier et deuxième ressorts de contact 120a, 120b et le courant électrique va passer à travers la plaque d'indexation de position 58, ce qui permet de détecter la fermeture du contact électrique entre les deux premiers ressorts de contact 120a, 120b. On note que les doigts 66a, 66b de la plaque d'indexation de position 58 viennent en contact de butée avec les premier et deuxième ressorts de contact 120a, 120b. Il n'y a donc aucun frottement ni usure lorsque la tige de commande 4 est poussée en avant en position T0 et qu'elle ferme le circuit entre les premier et deuxième ressorts de contact 120a, 120b. On note aussi que, du fait de la longueur différente des première et deuxième cavités 122a et 122b, on est assuré que la fermeture du contact électrique et l'introduction de la commande correspondante dans l'objet portable équipé du dispositif de commande 1 n'intervient qu'après le ressenti du déclic.

Lorsque les deux doigts 66a, 66b de la plaque d'indexation de position 58 sont en contact avec les premier et deuxième ressorts de contact 120a ,120b, le premier ressort de contact 120a logé dans la première cavité 122a la plus longue est à l'état comprimé. Par conséquent, lorsque l'utilisateur relâche la pression sur la tige de commande 4, ce premier ressort de contact 120a se détend et force le retour de la tige de commande 4 de sa position poussée instable T0 à sa première position stable T1. Les premier et deuxième ressorts de contact 120a, 120b jouent donc simultanément le rôle de pièces de contact électrique et de moyen de rappel élastique de la tige de commande 4 dans sa première position stable T1.

Depuis la première position stable T1, il est possible de tirer la tige de commande 4 en arrière dans une seconde position stable T2 (voir figure 12C). Au cours de ce mouvement, les extrémités 78 des tiges 86 du ressort de positionnement 80 vont passer en se déformant élastiquement des premiers creux 74a aux second creux 74b en franchissant les sommets 76 des deux ouvertures 70 ménagées dans les bras de guidage 62 de la plaque d'indexation de position 58. Lorsque la tige de commande 4 arrive dans sa seconde position stable T2, les deux doigts 66a, 66b de la plaque d'indexation de position 58 viennent buter contre des troisième et quatrième ressorts de contact 130a, 130b (voir figure 13) qui sont logés dans des troisième et quatrième cavités 132a, 132b ménagées dans le bâti inférieur 2. Ces troisième et quatrième ressorts de contact 130a et 130b peuvent être au choix des ressorts de contact hélicoïdaux, des lames ressorts ou autres. Les troisième et quatrième cavités 132a, 132b s'étendent préférentiellement verticalement pour des questions d'encombrement du dispositif de commande 1. Comme la plaque d'indexation de position 58 est électriquement conductrice, lorsque les doigts 66a, 66b viennent en contact avec les troisième et quatrième ressorts de contact 130a, 130b, le courant électrique passe à travers la plaque d'indexation de position 58 et l'on détecte la fermeture du contact électrique T2 entre ces ressorts de contact 130a, 130b.

On notera que, dans le cas de la position stable T2, les doigts 66a, 66b de la plaque d'indexation de position 58 viennent également en contact de butée avec les troisième et quatrième ressorts de contact 130a, 130b, de sorte que tout risque d'usure par frottement est évité. Par ailleurs, les troisième et quatrième ressorts de contact 130a, 130b sont capables de fléchir lorsque les doigts 66a, 66b de la plaque d'indexation de position 58 les heurtent, et donc d'absorber un éventuel manque de précision dans le positionnement de la plaque d'indexation de position 58.

De préférence, mais non obligatoirement, les troisième et quatrième ressorts de contact 130a, 130b sont agencés pour travailler en flexion (voir figures 14A et 14B). En effet, avec des ressorts de contact 130a, 130b dont le diamètre est constant, les doigts 66a, 66b de la plaque d'indexation de position 58 viennent en contact avec les ressorts de contact 130a, 130b selon une surface importante proche de leurs points d'ancrage dans le bâti inférieur 2 et le bâti supérieur 36. La proximité de la surface de contact avec les points d'ancrage des ressorts de contact 130a, 130b induit dans ces ressorts de contact 130a, 130b des contraintes de cisaillement qui peuvent conduire à l'usure prématurée et à la rupture de ces derniers. Pour résoudre ce problème, les ressorts de contact 130a, 130b présentent de préférence sensiblement à mi-hauteur une augmentation de diamètre 134 avec laquelle les doigts 66a, 66b de la plaque d'indexation de position 58 viennent en contact lorsque la tige de commande 4 est tirée dans sa position stable T2. A leur extrémité supérieure, les troisième et quatrième ressorts de contact 130a, 130b sont guidés dans deux trous 136 ménagés dans le bâti supérieur 36 et viennent en contact avec des deuxièmes plages de contact 138 prévues à la surface de la feuille de circuit imprimé flexible 128. On comprend que, lorsque l'on tire en arrière la tige de commande 4 dans sa position stable T2, les doigts 66a, 66b de la plaque d'indexation de position 58 viennent en contact selon une surface réduite avec les troisième et quatrième ressorts de contact 130a et 130b au niveau de leur plus grand diamètre 134, ce qui permet à ces ressorts de contact 130a, 130b de fléchir entre leurs deux points d'ancrage dans le bâti inférieur 2 et le bâti supérieur 36.

Sur la figure 15, les bâtis inférieur 2 et supérieur 36 ont été volontairement omis pour faciliter la compréhension du dessin. Comme représenté sur cette figure 15, la feuille de circuit imprimé flexible 128 est fixée sur une platine 140 située du côté d'un cadran de l'objet portable. Elle présente notamment une découpe 142 adaptée en forme et en dimension pour recevoir le bâti supérieur 36. Une portion 144 de la feuille de circuit imprimé flexible 128 reste libre (voir figure 16). Cette portion libre 144 de la feuille de circuit imprimé flexible 128 porte une pluralité de composants électroniques 146 ainsi que des troisièmes plages de contact 148 sur lesquelles sont fixés au moins un et, dans l'exemple représenté, deux capteurs inductifs 150. La fixation des capteurs inductifs 150 sur les troisièmes plages de contact 148 permet, via la feuille de circuit imprimé flexible 128, de relier ces capteurs inductifs 150 notamment à une source d'alimentation et à un microprocesseur (non représentés) logés dans l'objet portable. La source d'alimentation va fournir aux capteurs inductifs 150 l'énergie électrique nécessaire à leur fonctionnement, et le microprocesseur va recevoir et traiter les signaux fournis par les capteurs inductifs 150.

La portion libre 144 de la feuille de circuit imprimé flexible 128 est reliée au restant de la feuille de circuit imprimé flexible 128 par deux bandes 152 qui permettent de replier la portion libre 144 autour de l'assemblage du bâti supérieur 36 et du bâti inférieur 2, puis de rabattre la portion libre 144 contre la face inférieure 112 du bâti inférieur 2, de façon que les capteurs inductifs 150 pénètrent dans deux logements 156 ménagés dans la face inférieure 112 du bâti inférieur 2. Ainsi positionnés dans leurs logements 156, les capteurs inductifs 150 se trouvent précisément situés sous l'anneau aimanté 18, ce qui garantit une détection fiable du sens de rotation de la tige de commande 4.

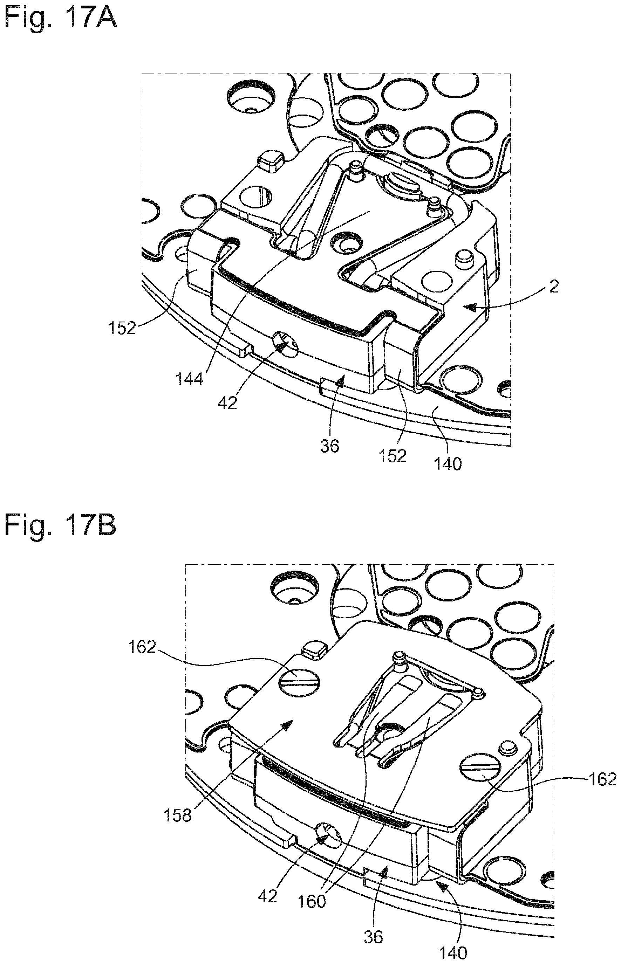

Une fois la portion libre 144 de la feuille de circuit imprimé flexible 128 rabattue contre le bâti inférieur 2 (voir figure 17A), l'ensemble est recouvert par une plaque de maintien 158 munie d'au moins un doigt élastique 160 (deux dans l'exemple représenté) qui exerce sur les capteurs inductifs 150 une force élastique de pression dirigée verticalement vers le haut de manière à plaquer ces capteurs inductifs 150 au fond de leurs logements 156 (voir figure 17B). Les doigts élastiques 160 appuient sur la feuille de circuit imprimé flexible 128 de préférence à l'endroit où les capteurs inductifs 150 sont fixés. La plaque de maintien 158 est fixée sur le bâti inférieur 2 par exemple au moyen de deux vis 162.

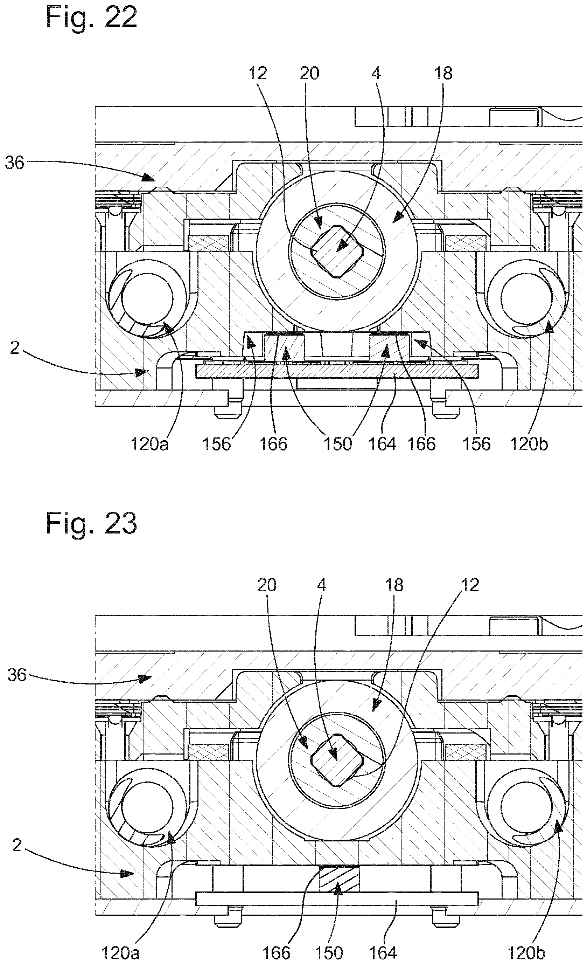

Dans un effort de simplification, il est possible (voir figure 22) de s'affranchir de la plaque de maintien 158 et de ses doigts élastiques 160 en fixant le (ou les) capteur(s) inductif(s) 150 sur une plaque de circuit imprimé rigide 164 reliée à la feuille de circuit imprimé flexible 128 par un élément conducteur par exemple du type des deux bandes 152. Une mince couche de colle 166 est déposée dans le fond des logements 156, puis la plaque de circuit imprimé rigide 164 est plaquée contre le bâti inférieur 2, de façon que les capteurs inductifs 150 se retrouvent collés dans le fond des logements 156. Il est même possible (voir figure 23) de s'affranchir des logements 156 et de simplement coller au moyen d'une mince couche de colle 166 ou de maintenir élastiquement au moyen de doigts élastiques 160 les capteurs inductifs 150 contre une surface d'appui 168 du bâti inférieur 2.

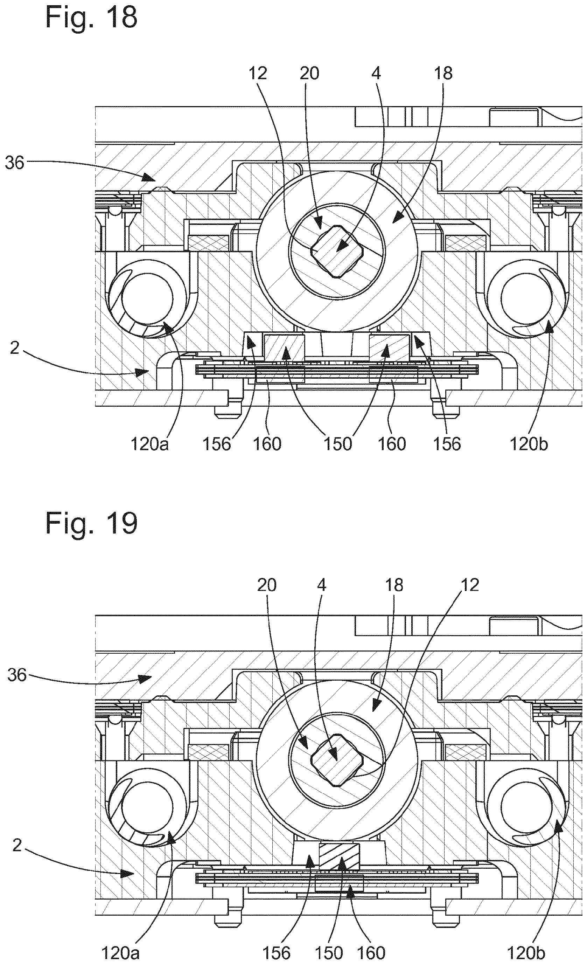

La tige de commande 4 est portée par le bâti inférieur 2 qui lui sert de berceau. De même, les deux capteurs inductifs 150 sont disposés dans les deux logements 156 ménagés dans ce même bâti inférieur 2 et sont plaqués contre le fond de ces logements 156 par un ou deux doigts élastiques 160 (voir figure 18). Par conséquent, la précision du positionnement relatif des capteurs inductifs 150 et de l'anneau aimanté 18 qui est monté fixe relativement à la tige de commande 4 est déterminée uniquement par la précision avec laquelle est réalisé le bâti inférieur 2. Or, la précision de fabrication de ce bâti inférieur 2, par exemple réalisé en plastique injecté ou en un matériau métallique amagnétique tel que du laiton, est suffisante pour garantir le bon positionnement des capteurs inductifs 150 et de l'anneau aimanté 18 même dans le cas d'une production en grande série. En outre, comme les capteurs inductifs 150 sont forcés élastiquement contre le fond des logements 156 par le (ou les) doigt(s) élastique(s) 160, cela permet de compenser d'éventuels jeux dus aux tolérances de fabrication. Ces tolérances de fabrication peuvent notamment provenir de l'étape de soudage des composants inductifs 150 sur la feuille de circuit imprimé flexible 128. Cette opération de soudage s'effectue par exemple dans un four au moyen d'une pâte à souder déposée sur les plages de contact 148 de la feuille de circuit imprimé flexible 128.

Le (ou les) capteurs inductifs 150 sont préférentiellement orientés de façon que leur élément sensible détecte une fluctuation de l'induction magnétique suivant la direction verticale z uniquement. Autrement dit, les capteurs inductifs sont totalement insensibles aux composantes horizontales suivant les axes orthogonaux x et y de l'induction magnétique.

Dans le cas où un seul capteur inductif 150 est prévu (voir figure 19), l'amplitude de la rotation et la position de la tige de commande 4 peuvent être déterminées avec une précision moyenne seulement. En effet, lorsque l'anneau aimanté 18 tourne sous l'effet de l'actionnement de la tige de commande 4, le capteur inductif 150 produit un signal sinusoïdal dont l'amplitude de la variation fluctue selon la valeur de l'angle considérée. Si l'on se trouve par exemple dans une zone proche de la valeur π/2, le signal sinusoïdal varie faiblement, de sorte que la quantité de déplacement de la tige de commande 4 et la position de celle-ci ne peuvent être déterminées qu'avec une précision moyenne. Par contre, si l'on se trouve dans une zone proche de la valeur π, le signal sinusoïdal fluctue fortement, de sorte que la quantité dont est tournée la tige de commande 4 et la position de celle-ci peuvent être déterminées avec une bonne précision.

Dans le cas où l'on peut se satisfaire d'une précision moyenne dans la détection de la position et de la quantité dont est tournée la tige de commande 4, le système décrit ci-dessus est tout à fait adapté. Cependant, dans le cas où une très bonne précision de mesure est requise, il est préférable d'équiper l'objet portable selon l'invention de deux capteurs inductifs 150. En effet, en prévoyant d'utiliser deux capteurs inductifs 150, il est possible de déterminer à la fois l'amplitude et le sens de rotation de la tige de commande 4 avec une précision accrue. Pour cela, les deux capteurs inductifs 150 sont agencés à égale distance de part et d'autre d'un plan vertical P de symétrie longitudinale de la tige de commande 4. De préférence, les deux capteurs inductifs 150 sont agencés par rapport à la tige de commande 4 de façon que, lorsque l'anneau aimanté 18 tourne sous l'effet de l'actionnement de la tige de commande 4, les deux capteurs inductifs 150 produisent des signaux sinusoïdaux sin(x) et sin(x+δ) qui sont déphasés l'un par rapport à l'autre d'un angle δ compris entre 60° et 120°, et de préférence sensiblement égal à 90°. Pour calculer l'agencement relatif des deux capteurs inductifs et de l'anneau aimanté 18, on peut par exemple procéder par itérations successives au moyen d'un logiciel de calcul par éléments finis.

Du fait du déphasage δ entre les signaux de mesure sinusoïdaux sin(x) et sin(x+δ) produits par les deux capteurs inductifs 150, lorsque l'on calcule la fonction arc-tangente du rapport entre ces deux signaux de mesure, on obtient une droite. Par conséquent, il est possible, à partir d'un mouvement rotatif de la tige de commande 4, d'obtenir du système formé par la tige de commande 4, l'anneau aimanté 18 et les deux capteurs inductifs 150 une réponse linéaire. Cette linéarisation de la rotation de la tige de commande 4 permet avantageusement d'effectuer une détection absolue de la position de la tige de commande 4. En d'autres termes, il est possible à tout moment de connaître le sens de rotation et la position de la tige de commande 4. En outre, du fait du déphasage de δ, on est constamment dans une situation dans laquelle, lorsque l'un des signaux de mesure sinusoïdaux sin(x) produit par les deux capteurs inductifs 150 varie peu, l'autre signal sinusoïdal sin(x+δ) varie plus fortement et inversement, de sorte que le rapport entre ces deux signaux donne toujours une information précise sur la rotation de la tige de commande 4.

On a mentionné ci-dessus que les capteurs inductifs 150 étaient préférentiellement orientés de façon que leur élément sensible ne détecte les fluctuations de l'induction magnétique que selon l'axe vertical z. Cette composante de l'induction magnétique est la somme des inductions selon l'axe z engendrées par l'anneau aimanté 18 et par le champ magnétique extérieur à l'objet portable. Or, les capteurs inductifs 150 étant très proches l'un de l'autre, l'influence qu'exerce sur eux le champ magnétique externe est sensiblement la même pour les deux capteurs inductifs 150. Par conséquent, en faisant le rapport entre les deux signaux sinusoïdaux sin(x) et sin(x+δ), on élimine la composante de l'induction magnétique due au champ magnétique extérieur à l'objet portable. La réponse du système formé par la tige de commande 4, l'anneau aimanté 18 et les capteurs inductifs 150 est donc totalement indépendante du champ magnétique extérieur, et il n'est pas nécessaire de prendre des dispositions pour blinder magnétiquement l'objet portable. De même, la réponse du système est indépendante de la température dans la mesure où la température a le même effet sur les deux capteurs inductifs.

Il va de soi que la présente invention n'est pas limitée au mode de réalisation qui vient d'être décrit et que diverses modifications et variantes simples peuvent être envisagées par l'homme du métier sans sortir du cadre de l'invention tel que défini par les revendications annexées. En particulier, les dimensions de l'anneau aimanté peuvent être étendues de façon à le faire correspondre à un cylindre creux. Selon un mode de réalisation simplifié illustré à la figure 23,

### Nomenclature

1. Dispositif de commande
2. Bâti inférieur
4. Tige de commande
X-X. Axe longitudinal de symétrie
6. Extrémité arrière
8. Couronne d'actionnement
10. Extrémité avant
12. Section carrée
14. Equipage magnétique
16. Palier lisse
18. Anneau aimanté
20. Bague-support
22a. Première section
D1. Premier diamètre extérieur
22b. Seconde section
D2. Deuxième diamètre extérieur
24. Epaulement
26. Trou carré
28. Logement cylindrique
D3. Premier diamètre intérieur
30. Trou annulaire
D4. Second diamètre intérieur
D5. Troisième diamètre extérieur
32. Collerette circulaire
34a. Première gorge
34b. Seconde gorge
36. Bâti supérieur
38. Première surface de réception
40. Deuxième surface de réception
42. Trou
44a, 46a. Troisième et quatrième surface de dégagement
44b, 46b. Surfaces de dégagement complémentaires
48. Carrure
50. Collerette annulaire
52. Section cylindrique
54. Section arrière
56. Rainure
58. Plaque d'indexation de position
60. Portion courbée
62. Bras de guidage
64. Plots
66a, 66b. Doigts
68. Rebord
70. Ouvertures
72. Profil
74a. Premier creux
74b. Second creux
76. Sommet
78. Extrémités
80. Ressort de positionnement
82. Bras
84. Base
86. Tiges
88. Ressort de limitation de déplacement
90. Partie centrale
92. Paire de bras élastiques
94. Paire de bras élastiques
96. Pattes rigides
98. Plaque de déboîtement
100. Segment droit
102. Première section transversale
104. Seconde section transversale
106. Pattes
108. Logement
110. Trou
112. Face inférieure
114. Premier profil en rampe
α. Première pente
116. Point de transition
118. Second profil en rampe
β. Seconde pente
120a, 120b. Premier et deuxième ressort de contact
122a, 122b. Première et deuxième cavité
124. Pattes de contact
126. Premières plages de contact
128. Feuille de circuit imprimé flexible
130a, 130b. Troisième et quatrième ressort de contact
132a, 132b. Troisième et quatrième cavité
134. Augmentation de diamètre
136. Trous
138. Deuxièmes plages de contact
140. Platine
142. Découpe
144. Portion libre
146. Composants électroniques
148. Troisièmes plages de contact
150. Capteurs inductifs
152. Bandes
156. Logements
158. Plaque de maintien
160. Doigts élastiques
162. Vis
164. Plaque de circuit imprimé rigide
166. Couche de colle
168. Surface d'appui

## Revendications

1. Objet portable comprenant un bâti (2) agencé pour servir de berceau à une tige de commande (4) dont l'actionnement en rotation permet de commander au moins une fonction électronique ou mécanique de l'objet portable, un anneau aimanté (18) étant entraîné en rotation par la tige de commande (4), la rotation de l'anneau aimanté (18) étant détectée par au moins un capteur inductif (150) maintenu en appui contre une surface (168) du bâti (2).

2. Objet portable selon la revendication 1, **caractérisé en ce que** le capteur inductif (150) est disposé dans un logement (156) du bâti (2) à l'intérieur duquel le capteur inductif (150) est maintenu par des moyens élastiques ou par collage.

3. Objet portable selon la revendication 2, **caractérisé en ce qu'**il comprend une plaque de maintien (158) munie d'au moins un doigt élastique (160) qui, par pression sur le capteur inductif (150), maintient ce capteur inductif (150) à l'intérieur du logement (156) dans lequel il est disposé.

4. Objet portable selon la revendication 3, **caractérisé en ce que** le capteur inductif (150) est fixé sur une feuille de circuit imprimé (128) et le doigt élastique (160) appuie sur la feuille de circuit imprimé (128) à l'endroit où le capteur inductif (150) est fixé.

5. Objet portable selon la revendication 4, **caractérisé en ce que** la feuille de circuit imprimé (128) est flexible et **en ce qu'**elle est rabattue sur le bâti (2) de sorte que le capteur inductif (150) soit disposé dans le logement (156).

6. Objet portable selon l'une quelconque des revendications 3 à 5, **caractérisé en ce que** le doigt élastique (160) garantit l'immobilisation du capteur inductif (150) selon une direction verticale (z).

7. Objet portable selon la revendication 6, **caractérisé en ce que** le doigt élastique (160) est agencé pour forcer le capteur inductif (150) contre un fond du logement (156) dans lequel il est disposé.

8. Objet portable selon l'une quelconque des revendications 6 ou 7, **caractérisé en ce que** le capteur inductif (150) comprend un élément sensible aux fluctuations de l'induction magnétique qui est orienté de façon que l'élément sensible détecte une fluctuation de l'induction magnétique suivant la direction verticale (z) uniquement.

9. Objet portable selon l'une quelconque des revendications 1 à 8, **caractérisé en ce qu'**il comprend deux capteurs inductifs (150) qui sont logés dans deux logements (156) du bâti (2) et qui sont disposés à égale distance de part et d'autre d'un plan vertical (P) de symétrie longitudinale de la tige de commande (4).

10. Objet portable selon la revendication 9, **caractérisé en ce que** les deux capteurs inductifs (150) sont agencés par rapport à la tige de commande (4) de façon que, lorsque l'anneau aimanté (18) tourne sous l'effet de l'actionnement de la tige de commande (4), les deux capteurs inductifs (150) produisent des signaux qui sont déphasés l'un par rapport à l'autre d'un angle δ compris entre 60° et 120°.
